(19) Europäisches Patentamt / European Patent Office / Office européen des brevets

(11) **EP 4 222 513 B1**

(12) **EUROPÄISCHE PATENTSCHRIFT**

(45) Veröffentlichungstag und Bekanntmachung des Hinweises auf die Patenterteilung:
**20.12.2023  Patentblatt 2023/51**

(21) Anmeldenummer: **22711439.4**

(22) Anmeldetag: **10.03.2022**

(51) Internationale Patentklassifikation (IPC):
**G01R 31/392** (2019.01)     **G01R 31/367** (2019.01)
**B60L 58/10** (2019.01)

(52) Gemeinsame Patentklassifikation (CPC):
**G01R 31/392; B60L 58/12; B60L 58/16;**
**G01R 31/367;** B60L 2240/545; B60L 2240/547;
B60L 2240/549; G01R 31/371; Y02T 10/70

(86) Internationale Anmeldenummer:
**PCT/AT2022/060068**

(87) Internationale Veröffentlichungsnummer:
**WO 2022/221891 (27.10.2022 Gazette 2022/43)**

(54) **ERMITTLUNG DES GESUNDHEITSZUSTANDS EINER FAHRZEUGBATTERIE**

DETERMINING THE STATE OF HEALTH OF A VEHICLE BATTERY

DÉTERMINATION DE L'ÉTAT DE SANTÉ D'UNE BATTERIE DE VÉHICULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.04.2021   AT 502922021**

(43) Veröffentlichungstag der Anmeldung:
**09.08.2023   Patentblatt 2023/32**

(73) Patentinhaber: **Aviloo GmbH**
**2351 Wiener Neudorf (AT)**

(72) Erfinder:
• **BERGER, Wolfgang**
**2362 Biedermannsdorf (AT)**
• **MAYERHOFER, Nikolaus**
**2392 Sulz im Wienerwald (AT)**

(74) Vertreter: **Wildhack & Jellinek Patentanwälte Patentanwälte OG**
**Landstraßer Hauptstraße 50**
**1030 Wien (AT)**

(56) Entgegenhaltungen:
DE-A1-102019 111 979     US-A1- 2016 349 330
US-A1- 2020 269 722     US-B1- 10 942 223

**Beschreibung**

Die Erfindung betrifft ein Verfahren und eine Vorrichtung zur Ermittlung des Gesundheitszustands der Fahrzeugbatterie eines Elektrofahrzeugs oder Hybridelektrofahrzeugs gemäß Patentanspruch 1 bzw. 13.

Batteriebetriebene Fahrzeuge wie Autos oder Fähren, aber auch stationäre Batteriespeichersysteme gewinnen im Zusammenhang mit der zunehmenden Nutzung erneuerbarer Energiequellen und der Reduktion des COs-Austoßes laufend an Bedeutung.

Der Gesundheitszustand (State of Health, SoH) ist eines der wichtigsten Charakteristika einer Batterie. Aufgrund komplexer chemischer Reaktionen im Inneren der Batterie nimmt die nutzbare Kapazität im Laufe der Zeit ab und ihr Gesundheitszustand sinkt. Der Gesundheitszustand setzt sich aus den Unterschieden verschiedener Parameter zwischen der Batterie im Neuzustand und im vermessenen Zustand zusammen. Die Parameter umfassen Kapazität, Energie, EC-Parameter und thermische Parameter.

Batterien weisen zumeist ein eigenes Batteriemanagementsystem auf, das in der Batterie integriert ist und die Batterie in einem sicheren Betriebszustand hält. Derartige Batteriemanagementsysteme sind dazu in der Lage, z.B. individuelle Zellenspannungen, den Batteriepackstrom oder Batteriemodultemperaturen auszulesen. Weitere Funktionen eines derartigen Batteriemanagementsystems sind die Schätzung des Ladezustands (State of Charge, SoC) und des Gesundheitszustands.

Aus dem Stand der Technik bekannte Batteriemanagementsysteme verfügen zumeist über einen kostengünstigen, einfachen Mikrocontroller. Daher müssen die Algorithmen, die zur Berechnung des Gesundheitszustands und des Ladezustands vom Batteriemanagementsystem genutzt werden, besonders rechenleistungssparend sein und sind deshalb entsprechend fehlerbehaftet. Der Ladezustand der Batterie wird bei den bekannten Batteriemanagementsystemen zumeist mittels eines Coulomb-Zählers kombiniert mit der Leerlaufspannungskennlinie der Batterie berechnet und basiert daher auf im Batteriemanagementsystem hinterlegten Labordaten und Algorithmen. Der Gesundheitszustand wird meist unter Heranziehung von vorgegebenen Alterungsmodellen berechnet. Aufgrund der vorgegebenen Daten und Modelle stellt der für die jeweilige Batterie errechnete Gesundheitszustand jedoch nur eine ungenaue Abschätzung des tatsächlichen Gesundheitszustands dar, da keine individuelle Anpassung an den jeweiligen Batterie- und/oder Fahrzeugtyp möglich ist.

Aus der EP 3224632 B1 ist ein Batteriemanagementsystem mit einem fahrzeuginternen und einem fahrzeugexternen Untersystem bekannt. Das fahrzeugexterne Untersystem kann Daten des fahrzeuginternen Untersystems speichern und anhand der gespeicherten Daten fahrzeugexterne Batteriemodelle erstellen und diese in Parameter einfacher fahrzeugexterner Batteriemodelle abzubilden. Diese Parameter werden dann an das fahrzeuginterne Untersystem übermittelt, das basierend auf diesen Parametern ein einfaches fahrzeuginternes Batteriemodell auswählt und anhand des einfachen fahrzeuginternen Batteriemodells dann vom Batteriemanagementsystem ein Batteriestatus berechnet. Mit einer derartigen Vorgehensweise ist jedoch ebenfalls nur eine näherungsweise Abschätzung des Batteriestatus möglich, da aufgrund der begrenzten Speicher- und Rechenleistung des Batteriemanagementsystems Berechnungen lediglich mit einem vereinfachten fahrzeuginternen Batteriemodell durchgeführt werden können.

US 20160349330 A1 beschreibt eine Anordnung zur Ermittlung des Gesundheitszustandes der Fahrzeugbatterie eines Elektrofahrzeuges. Die Bestimmung des Gesundheitszustandes basiert durch den in Datenkommunikation stehenden Server unter Heranziehung eines auf maschinellem Lernen basierenden fahrzeugspezifischen Batteriemodells, wobei das Batteriemodell durch den Serienwiderstand R1 und das RC-Glied R2, C2 gebildet wird.

US 20200269722 A1 beschreibt Verfahren samt korrespondierender Vorrichtungen zur Optimierung der Performance von Batteriepacks eines Fahrzeugs. Dabei werden Daten betreffend Zellen eines Batteriepacks eines Fahrzeugs aus einer Flotte von Fahrzeugen ermittelt und mittels Verfahren des maschinellen Lernens wird ein *predictive model* erstellt. Dieses *predictive model* wird an das Fahrzeug übermittelt und die Parameter der Zellen des Batteriepacks werden entsprechend angepasst.

DE 102019111979 A1 offenbart ein Verfahren zur Server-seitigen Charakterisierung einer wiederaufladbaren Batterie. Dabei werden Betriebswerte für eine Kapazität und eine Impedanz der Batterie erhalten und basierend auf den Betriebswerten eine Zustandsvorhersage für die Batterie in mehreren Iterationen durchgeführt, wobei in jeder Iteration eine Simulation eines elektrischen und eines thermischen Zustands der Batterie durchgeführt wird.

Aufgabe der Erfindung ist es daher, diesbezüglich Abhilfe zu schaffen und ein Verfahren und eine Vorrichtung zur Ermittlung des Gesundheitszustands der Fahrzeugbatterie eines Elektrofahrzeugs oder Hybridelektrofahrzeugs bereitzustellen, die eine individualisierte und genaue Einschätzung des Gesundheitszustands der Fahrzeugbatterie ermöglichen.

Die Erfindung löst diese Aufgabe bei einem Verfahren zur Ermittlung des Gesundheitszustands der Fahrzeugbatterie eines Elektrofahrzeugs oder Hybridelektrofahrzeugs gemäß dem Oberbegriff von Patentanspruch 1 mit den kennzeichnenden Merkmalen von Patentanspruch 1. Erfindungsgemäß ist dabei vorgesehen: dass als fahrzeugspezifisches Batteriemodell zunächst ein vom Typ der Fahrzeugbatterie abhängiges Batteriegrundmodell in Form eines elektrischen Ersatzschaltbild-Modells herangezogen wird, wobei das Batteriegrundmodell eine Spannungsquelle, einen Innenwiderstand und eine Anzahl von, insbesondere zwei, RC-Gliedern umfasst,

- wobei der Innenwiderstand und die RC-Glieder als Funktion der Zelltemperatur und des Ladezustands festgelegt werden,
- wobei eine Leerlaufspannungskennlinie als Funktion des Ladezustands festgelegt wird und
- wobei die Zelltemperatur mittels eines thermischen Modells in Abhängigkeit von dem gemessenen Batteriepackstrom, EC-Parametern, insbesondere Parametern des elektrischen Ersatzschaltbild-Modells, der Batteriemodultemperatur und der Umgebungstemperatur bestimmt wird.

Mit einem erfindungsgemäßen Verfahren ist es vorteilhafterweise möglich, eine exakte Abschätzung des Gesundheitszustands der Fahrzeugbatterie zu erzielen, die auf einem individuell auf die untersuchte Fahrzeugbatterie bzw. das untersuchte Fahrzeug abgestimmten fahrzeugspezifischen Batteriemodell basiert. Da die Berechnung auf einem externen, vom Fahrzeug getrennten Server durchgeführt wird, ist es nicht erforderlich, ein vereinfachtes Batteriemodell zu wählen, wie dies bei einer Berechnung durch das Batteriemanagementsystem mit seiner begrenzten Rechenleistung und seinem begrenzten Speicherplatz erforderlich wäre. Ganz im Gegenteil dazu kann aufgrund der externen Berechnung auf einem Server das fahrzeugspezifische Batteriemodell beliebig komplex gestaltet werden und eine Vielzahl von Parametern, aktuellen und historischen Daten der untersuchten Fahrzeugbatterie, sowie ggf. zur Verfügung stehende Labordaten und Daten weiterer Fahrzeugbatterien in die Berechnung des Gesundheitszustands einfließen, was die Genauigkeit der Berechnung vorteilhafterweise wesentlich erhöht.

Weiters ist ein derartiges Batteriegrundmodell vielseitig einsetzbar und einfach für z.B. verschiedene Fahrzeugtypen und Batteriealterungszustände, sowie Umgebungsbedingungen adaptierbar.

Unter einem RC-Glied wird im Zusammenhang mit der Erfindung eine Schaltung verstanden, die aus einem ohmschen Widerstand und einem Kondensator aufgebaut ist.

Eine rasche und einfache aber gleichzeitig zuverlässige Parametrierung der Batterieparameter des Batteriegrundmodells kann erzielt werden, wenn, insbesondere vorab, den Batterieparametern des Batteriegrundmodells Werte auf Grundlage der Vermessung einzelner Zellen der Fahrzeugbatterie, insbesondere der Messung der Zellenspannung und des Zellenstromes einzelner Zellen, zugeordnet werden,
wobei insbesondere vorgesehen ist, dass die Leerlaufspannungskurve für zumindest eine einzelne Zelle, vorzugsweise mehrere einzelne Zellen, ermittelt wird und auf Grundlage der für die einzelne Zelle ermittelten Leerlaufspannungskurve die Leerlaufspannungskurve der Fahrzeugbatterie abgeschätzt wird.

Eine hinsichtlich z.B. des spezifischen Alterungsprozesses, der individuellen Beschaffenheit und des Ladeverhaltens einer Fahrzeugbatterie besonders gut angepasstes fahrzeugspezifische Batteriemodell kann bereitgestellt werden, wenn die den Batterieparametern des Batteriegrundmodells zugeordneten Werte auf Grundlage der während der Belastung der Fahrzeugbatterie ermittelten Batterieparameter angepasst werden und derart das fahrzeugspezifische Batteriemodell erstellt wird.

Eine weitere Verbesserung der Übereinstimmung des fahrzeugspezifischen Batteriemodells mit der tatsächlichen Fahrzeugbatterie kann erzielt werden, wenn die den Batterieparametern des Batteriegrundmodells zugeordneten Werte in Abhängigkeit von der während der Belastung der Fahrzeugbatterie ermittelten Zelltemperatur und/oder dem Ladezustand und/oder der Alterung der Fahrzeugbatterie angepasst werden.

Eine besonders zuverlässige Anpassung der Werte der Batterieparameter des Batteriegrundmodells kann erzielt werden,

- wenn die Fahrzeugbatterie belastet wird, indem eine Testfahrt mit dem Fahrzeug unternommen wird,
- wenn für die Batterieparameter des Batteriegrundmodells für den während der Testfahrt vorherrschenden Ladezustand und die vorherrschende Zelltemperatur gültige Werte ermittelt werden, und
- wenn die derart ermittelten Werte mittels der, insbesondere erfindungsgemäß, auf Grundlage der Vermessung einzelner Zellen der Fahrzeugbatterie bestimmten Werte auf eine vorgegebene Temperatur, insbesondere von 25°C, normiert und zur Erstellung des fahrzeugspezifischen Batteriemodells auf einen vorgegebenen Ladezustandsbereich, insbesondere von 0 bis 100%, extrapoliert werden.

Die Genauigkeit der Übereinstimmung des fahrzeugspezifischen Batteriemodells mit der tatsächlichen Fahrzeugbatterie kann weiter verbessert werden, wenn im Batteriegrundmodell und/oder im fahrzeugspezifischen Batteriemodell zwischen den Zellen der Fahrzeugbatterie vorliegende Innenwiderstände, insbesondere verursacht durch Verkabelung und/oder Verschweißung, berücksichtigt werden.

Eine Möglichkeit einer Reichweitenschätzung beim aktuellen Batteriezustand kann bei einem erfindungsgemäßen Verfahren bereitgestellt werden, wenn das fahrzeugspezifische Batteriemodell einem vorgegebenen Testzyklus, insbesondere einem WLTP-Zyklus, unterworfen wird und eine Reichweitenschätzung beim aktuellen Gesundheitszustand der Fahrzeugbatterie durchgeführt wird,

wobei insbesondere vorgesehen ist, dass das fahrzeugspezifische Batteriemodell gemäß einem vorgegebenen Stromprofil mit Strom versorgt wird.

Eine erste Möglichkeit zur Belastung der Fahrzeugbatterie im Rahmen eines erfindungsgemäßen Verfahrens kann bereitgestellt werden, wenn die Fahrzeugbatterie belastet wird, indem eine Vollentleerungs-Testfahrt mit dem Fahrzeug unternommen wird, wobei die Fahrzeugbatterie während der Vollentleerungs-Testfahrt von ihrem vollständig geladenen Zustand bis zu ihrem vollständig entladenen Zustand entleert wird.

Eine weitere Möglichkeit zur Belastung der Fahrzeugbatterie im Rahmen eines erfindungsgemäßen Verfahrens mit der die Testzeit wesentlich verkürzt werden kann, kann bereitgestellt werden, wenn die Fahrzeugbatterie belastet wird, indem

- eine Ladung der Fahrzeugbatterie entsprechend zumindest einem vorgegebenen Lademuster durchgeführt wird und/oder
- eine Teilentleerungs-Testfahrt mit dem Fahrzeug unternommen wird, wobei die Fahrzeugbatterie während der Teilentleerungs-Testfahrt teilweise entleert wird und die während der Teilentleerungs-Testfahrt ermittelten Batterieparameter unter Heranziehung von historischen Daten und/oder Labordaten auf den vollständig entleerten Zustand extrapoliert werden.

Eine weitere Möglichkeit zur Belastung der Fahrzeugbatterie im Rahmen eines erfindungsgemäßen Verfahrens mit der die Testzeit wesentlich verkürzt werden kann und auch keine Testfahrt mit dem Fahrzeug notwendig ist, kann bereitgestellt werden, wenn basierend auf dem fahrzeugspezifischen Batteriemodell unter Belastung auf einem Prüfstand die Leerlaufspannung der Fahrzeugbatterie mittels EC-Parameter berechnet wird,

- wobei der Zusammenhang zwischen der Leerlaufspannung und dem Ladezustand einzelner Zellen der Fahrzeugbatterie, insbesondere die Leerlaufspannungs-Ladezustand-Kurve, vorgegeben wird,
- wobei der aktuelle Ladezustand der Fahrzeugbatterie basierend auf der Leerlaufspannung ermittelt wird und
- wobei der Gesundheitszustand der Fahrzeugbatterie ermittelt wird, indem mittels eines Coulomb-Zählers und der entsprechenden Änderung des Ladezustands auf den vollständig entleerten oder geladenen Zustand extrapoliert wird.

Um den Gesundheitszustand der Fahrzeugbatterie auch zeitverzögert und offline, d.h. nach Abschluss der Belastung der Fahrzeugbatterie berechnen zu können, kann vorgesehen sein, dass der Gesundheitszustand der Fahrzeugbatterie berechnet wird, nachdem die Belastung der Fahrzeugbatterie und die Übertragung der während der Belastung der Fahrzeugbatterie ermittelten Batterieparametermesswerte an den Datenspeicher abgeschlossen ist.

Um auch den Gesundheitszustand von Fahrzeugen bzw. Fahrzeugtypen mit unterschiedlichsten Datenqualitäten bei den übermittelten Batterieparametern berechnen zu können, kann vorgesehen sein, dass die an den Datenspeicher übermittelten Batterieparameter einzelnen Datenverarbeitungsschritten, insbesondere einer Glättung und/oder Synchronisierung und/oder einem Resampling, unterzogen werden.

Aufgabe der Erfindung ist es weiters, eine Anordnung zur Ermittlung des Gesundheitszustands der Fahrzeugbatterie eines Elektrofahrzeugs oder Hybridelektrofahrzeugs bereitzustellen, die insbesondere dazu ausgebildet sein kann, ein erfindungsgemäßes Verfahren durchzuführen. Die Erfindung löst diese Aufgabe bei einer Anordnung gemäß dem Oberbegriff von Patentanspruch 13 mit den kennzeichnenden Merkmalen von Patentanspruch 13.

Erfindungsgemäß ist dabei vorgesehen, dass der Server dazu ausgebildet ist, als fahrzeugspezifisches Batteriemodell zunächst ein vom Typ der Fahrzeugbatterie abhängiges Batteriegrundmodell in Form eines elektrischen Ersatzschaltbild-Modells heranzuziehen, wobei das Batteriegrundmodell eine Spannungsquelle, einen Innenwiderstand und eine Anzahl von, insbesondere zwei, RC-Gliedern umfasst,

- wobei der Innenwiderstand und die RC-Glieder als Funktion der Zelltemperatur und des Ladezustands festgelegt werden,
- wobei eine Leerlaufspannungskennlinie als Funktion des Ladezustands festgelegt wird und
- wobei die Zelltemperatur mittels eines thermischen Modells in Abhängigkeit von dem gemessenen Batteriepackstrom, EC-Parametern, insbesondere Parametern des elektrischen Ersatzschaltbild-Modells, der Batteriemodultemperatur und der Umgebungstemperatur festgelegt wird.

Weitere Vorteile und Ausgestaltungen der Erfindung ergeben sich aus der Beschreibung und den beiliegenden Zeichnungen.

Die Erfindung ist im Folgenden anhand von besonders vorteilhaften, aber nicht einschränkend zu verstehenden Ausführungsbeispielen in den Zeichnungen schematisch dargestellt und wird unter Bezugnahme auf die Zeichnungen beispielhaft beschrieben.

Im Folgenden zeigen schematisch:

Fig. 1 ein Ausführungsbeispiel eines Ersatzschaltbilds eines Batteriegrundmodells
Fig. 2 eine schematische Darstellung des Ablaufs der Erstellung eines fahrzeugspezifischen Batteriemodells,
Fig. 3 einen Vergleich zwischen simulierter und gemessener Zellspannung während eines Fahrzyklus,
Fig. 4 ein Ausführungsbeispiel eines thermischen Modells,

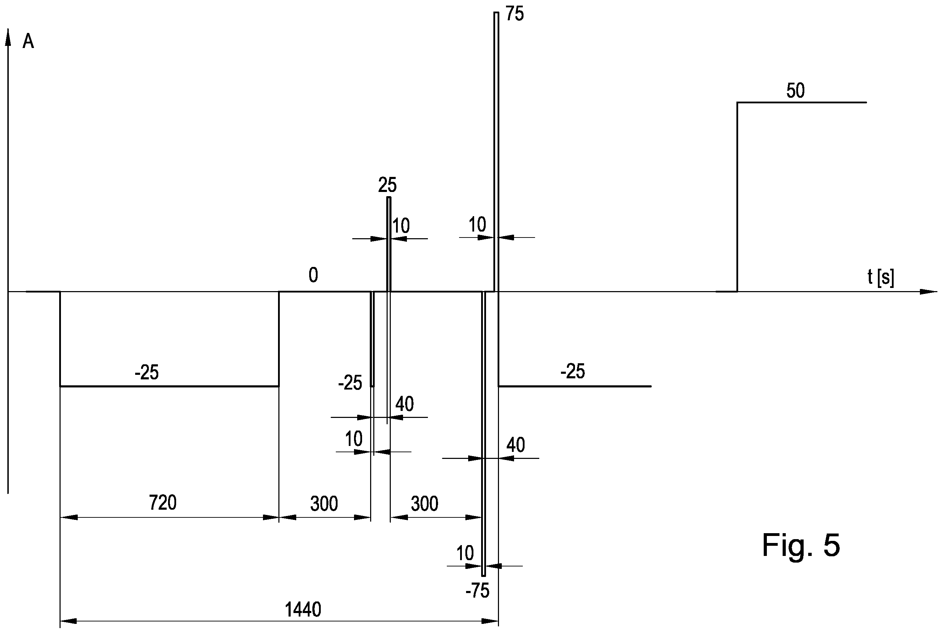

Fig. 5 einen beispielhaften Verlauf eines HPPC-Zyklus,
Fig. 6 ein Ausführungsbeispiel der Leerlaufspannungskennlinie für einzelne Zellen bzw. die Fahrzeugbatterie,
Fig. 7 ein Ausführungsbeispiel für die Berechnung der Leerlaufspannungskennlinie aus einer Lade- und einer Entladekurve.

Da es sich bei den zur Beschreibung des Gesundheitszustands SoH einer Fahrzeugbatterie zu berücksichtigenden Einflussfaktoren um komplexe, meist nicht lineare Zusammenhänge handelt und diese wiederum von vielen unterschiedlichen Parametern abhängig sind, ist eine möglichst umfangreiche Datenbasis notwendig, um ein datenbasiertes Modell einer Fahrzeugbatterie zu erstellen. Auf Algorithmen des maschinellen Lernens basierende Batteriemodelle benötigen in diesem Zusammenhang eine möglichst umfangreiche Datenbasis mit Fahrdaten von verschiedenen Fahrzeugen eines Typs, über ein breites Spektrum an km-Ständen. Das bedeutet, es werden Fahrzeuge mit km-Ständen von 0-10.000 km, 10-50.000 km, 50-100.000 km usw. benötigt. Um ein fahrzeugspezifisches Batteriemodell möglichst robust gegen statistische Ausreißer zu machen, sollten von jeder Kategorie mehrere Fahrzeuge (z.B. 10) vorhanden sein. Besonders in den ersten Jahren nach Verkaufsstart eines neuen Fahrzeugmodells ist die Fahrzeugverfügbarkeit mit hohen km-Ständen (100.000 km und mehr) jedoch nicht gegeben.

Im Folgenden wird ein Ausführungsbeispiel eines erfindungsgemäßen Verfahrens bzw. einer erfindungsgemäßen Anordnung zur Ermittlung des Gesundheitszustands SoH der Fahrzeugbatterie eines Elektrofahrzeugs im Detail beschrieben und vorteilhafte Optionen angegeben. Diese Ausführungsbeispiel ist jedoch nicht einschränkend zu verstehen und mit einem erfindungsgemäßen Verfahren bzw. einer erfindungsgemäßen Anordnung kann auch der Gesundheitszustand SoH von z.B. eines Elektrofahrzeugs (battery electric vehicle BEV) oder eines plug-in Hybridelektrofahrzeugs (PHEV), aber auch anderer Batteriesysteme, wie sie in Fähren oder Flugzeugen, sowie stationären Speichersystemen eingesetzt werden, berechnet werden.

Bei einem erfindungsgemäßen Verfahren zur Ermittlung des Gesundheitszustands der Fahrzeugbatterie wird einerseits die Fahrzeugbatterie belastet, während eine Reihe vorgegebener Batterieparameter, vorzugsweise in Echtzeit, gemessen werden und andererseits wird ein modellbasierter Ansatz mit einem fahrzeugspezifischen Batteriemodell FM (Fahrzeugmodell) zur Berechnung des Gesundheitszustands verwendet. Ein derartiger modellbasierter Ansatz ist vor allem für die Berechnung des Gesundheitszustands SoH der Batterie von Gebrauchtwagen in deren ersten fünf Lebensjahren besonders vorteilhaft, bzw. solange die Fahrzeuge unter einem km-Stand von 100.000 km bleiben.

Bei diesen vorgegebenen Batterieparametern kann es sich z.B. um Batteriepackspannung und Batteriepackstrom und/oder Ladezustand, aber auch um Zellenspannung, Batteriemodultemperatur und/oder Ladezustand einzelner Zellen der Batterie handeln. Diese Batterieparameter können während der Belastung der Fahrzeugbatterie z.B. durch das in die Fahrzeugbatterie integrierte Batteriemanagementsystem des Fahrzeugs gemessen werden.

**Anordnung:**

Die gemessenen Batterieparameter werden anschließend an einen vom Fahrzeug getrennten Datenspeicher, beispielsweise einen Cloud-Speicher, übertragen, was annähernd in Echtzeit während der Belastung der Fahrzeugbatterie, oder auch nach Abschluss der Belastung und Messung der Batterieparameter erfolgen kann.

Die Berechnung des Gesundheitszustands SoH der Fahrzeugbatterie erfolgt anschließend auf einem mit dem Datenspeicher in Datenkommunikation stehenden Server unter Heranziehung des fahrzeugspezifischen Batteriemodells und basierend auf den übertragenen Batterieparametern. Diese Berechnung des Gesundheitszustands SoH der Fahrzeugbatterie kann vorzugsweise offline, z.B. im Anschluss an die Messung der Batterieparameter und nach Abschluss der Datenübertragung an den Datenspeicher erfolgen. Optional ist es auch möglich, dass der Datenspeicher und der Server kombiniert sind.

Die Berechnung des Gesundheitszustands SoH der Fahrzeugbatterie auf einem externen, vom Fahrzeug getrennten Server bringt den erheblichen Vorteil mit sich, dass das Batteriemanagementsystem, wie eingangs erwähnt, weiterhin mit einem einfachen Mikrocontroller auskommen kann und dennoch eine komplexe Berechnung des Gesundheitszustands der Fahrzeugbatterie basierend auf einer großen Anzahl von Einflussfaktoren möglich ist. Dazu sind die für die Berechnung des Gesundheitszustands der Fahrzeugbatterie erforderlichen Algorithmen auf dem Server hinterlegt und alle Berechnungen werden auf dem Server ausgeführt und eine Hinterlegung bzw. Berechnung im Mikrocontroller des Batteriemanagementsystems ist vorteilhafterweise nicht erforderlich. Optional kann ein derartiger Server auch ein Userinterface aufweisen, auf dem ein Benutzer Einstellungen auswählen kann.

Auch können die während der Belastung gemessenen Batterieparameter optional auf dem Server und/oder im Datenspeicher einzelnen Datenverarbeitungsschritten unterworfen werden. Eine derartige Datenaufbereitung ist besonders vorteilhaft, da verschiedene Fahrzeuge bzw. Fahrzeugtypen unterschiedliche Datenqualität bei den übermittelten Batterieparametern aufweisen. Bedingt durch unterschiedliche Fahrzeug- und Batteriemanagementsystem-Hersteller werden die Batteriedaten in unterschiedlichen Qualitäten hinsichtlich Abtastrate und Auflösung der Batterieparameter zur Verfügung gestellt. Dies liegt hauptsächlich daran, dass hinsichtlich Batteriedaten keine Standards existieren. Im Rahmen einer solchen Datenaufbereitung können z.B. zunächst Ausreißer in den gemessenen Batterieparametern gelöscht werden, bevor anschließend die übermittelten Messwerte einer Glättung, einer Synchronisierung und/oder einem Resampling, um eine äquidistante Datenverteilung zu erhalten, unterzogen werden. Derartige Datenverarbeitungsschritte sind besonders vorteilhaft, um das fahrzeugspezifische Batteriemodell universell für alle Fahrzeugtypen und damit Datenqualitäten bereitstellen zu können.

Durch eine derartige zentrale Datenaufbereitung, Analyse und Algorithmik kann eine laufende Verbesserung der Berechnung des Gesundheitszustands insbesondere hinsichtlich Genauigkeit und Testzeitverkürzung erzielt werden, da übermittelte Rohdaten, sowie auch aufbereitete Daten dauerhaft verfügbar bzw. gespeichert sind und so in die Berechnung des Gesundheitszustands einfließen können.

Eine große Anzahl von Einflussfaktoren in die Berechnung des Gesundheitszustands einfließen zu lassen bzw. Datenverarbeitungsschritte bei den gemessenen Batterieparametern zu setzen, wäre aufgrund der eingeschränkten Rechenleistung der üblicherweise in Batteriemanagementsystemen eingesetzten Mikrocontroller nur eingeschränkt oder gar nicht möglich.

Die Übertragung der ermittelten Batterieparameter erfolgt mittels einer an den Diagnoseanschluss des Fahrzeugs ansteckbaren Datenübertragungseinheit. Eine derartige Datenübertragungseinheit kann während der Belastung der Fahrzeugbatterie z.B. an den OBD2-Port oder den DoIP (Diagnostics over Internet Protocol)-Port des Fahrzeugs oder auch einen beliebigen anderen CAN-Bus (z.B. des Antriebsstrangs, des Entertainmentsystems oder des Fahrgestells) des Fahrzeugs angeschlossen werden. Es können dabei alle Arten von Fahrzeugen wie PKW, LKW, Busse, Schiffe, Motorräder sowie e-Bikes und auch stationäre Speicher diagnostiziert werden.

In der Datenübertragungseinheit sind Kommunikationsprotokolle für die verschiedenen Fahrzeugtypen hinterlegt, die es ermöglichen, die vom Batteriemanagementsystem ermittelten Batterieparameter auszulesen und z.B. mittels WiFi, LTE, Bluetooth oder Ethernet an den Datenspeicher zu übermitteln. Je nach Anwendungsfall kann hier ein bestimmter Übertragungspfad ausgewählt werden. Wie zuvor bereits erwähnt, kann die Übertragung der vom Batteriemanagementsystem gemessenen Batterieparameter quasi in Echtzeit erfolgen, oder in einem gepufferten Modus, bei dem die Messwerte gesammelt und zwischengespeichert werden und erst übertragen werden, wenn eine Internetverbindung hergestellt wurde.

Alternativ dazu ist es aber auch möglich, dass die während der Belastung der Fahrzeugbatterie ermittelten Batterieparameter auf einem anderen Weg an den Datenspeicher übermittelt werden, was die Berechnung des Gesundheitszustands SoH der Fahrzeugbatterie mit einem erfindungsgemäßen Verfahren in keiner Weise einschränkt, so lange die Batterieparameter während einer Belastung der Fahrzeugbatterie gemessen wurden.

**Batteriegrundmodell GM:**

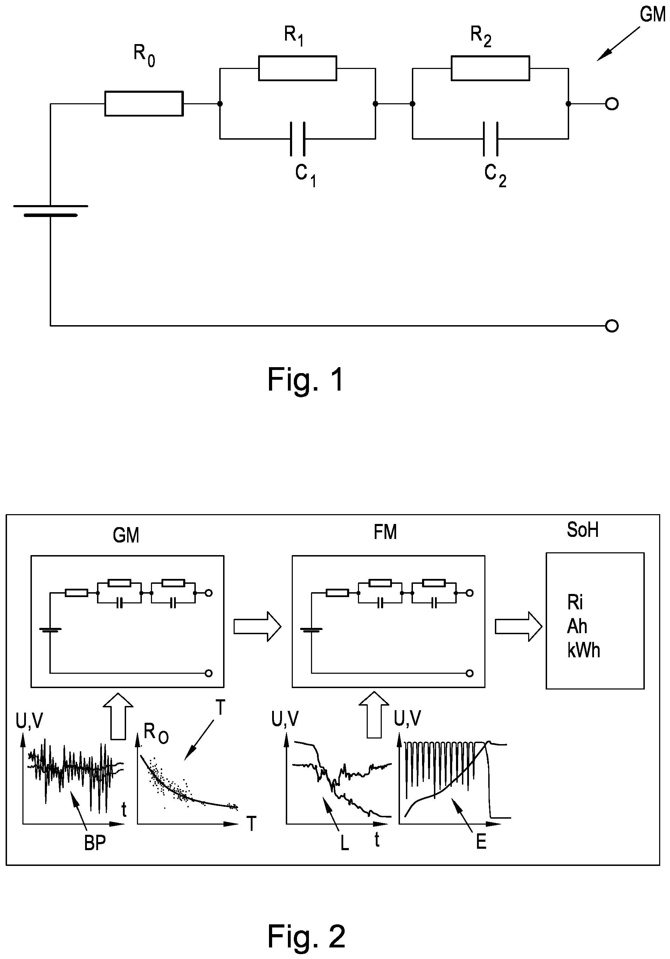

Für die Erstellung des fahrzeugspezifischen Batteriemodells FM wird im ersten Ausführungsbeispiel zunächst, wie in Fig. 1 gezeigt, ein Batteriegrundmodell GM erstellt, welches danach für die verschiedenen Fahrzeugtypen fein abgestimmt wird, um dann das fahrzeugspezifische Batteriemodell FM zu erhalten, das an die Alterung der Fahrzeugbatterie, sowie den Fahrzeug- und Batterietyp angepasst ist (siehe schematische Überblicksdarstellung in Fig. 2).

Das Batteriegrundmodell GM in Fig. 1 ist ein elektrisches Ersatzschaltbild- bzw. Equivalent Circuit (EC)-Modell, das die Spannung der Fahrzeugbatterie in Abhängigkeit von Strom und Ladezustand über einen Innenwiderstand $R_0$ und zwei RC-Glieder $RC_1$, $RC_2$ beschreibt.

Ein derartiges EC-Modell ist eine komplexe mathematische Beschreibung für eine Batterie, wobei das Batteriegrundmodell GM, wie in Fig. 1 ersichtlich ist, zunächst für jedes Fahrzeug gleich gewählt wird.

Der Innenwiderstand $R_0$ und die RC-Glieder $RC_1$, $RC_2$ sind im ersten Ausführungsbeispiel als Funktionen der Zelltemperatur und des Ladezustands der einzelnen Zellen festgelegt, die Leerlaufspannungskennlinie (Open Circuit Voltage) OCV als Funktion des Ladezustands und die Zelltemperatur wird mittels eines thermischen Modells in Abhängigkeit von dem gemessenen Batteriepackstrom, den EC-Parametern, der Batteriemodultemperatur und der Umgebungstemperatur berechnet. Hierauf wird im Folgenden näher eingegangen.

EC-Parameter Identifikation:

Die EC-Parameter, d.h. die Parameter des elektrischen Ersatzschaltbilds- bzw. Equivalent Circuit (EC)-Modells, werden mit Hilfe verschiedener Least Squares-Algorithmen identifiziert. Grundlage für die Identifikation ist die exakte Leerlaufspannungskennlinie OCV. Anschließend werden basierend auf der Spannungsdifferenz $U_{EC}$ zwischen Batteriespannung $U_{Batt}$ und der Leerlaufspannungskennlinie OCV die EC-Parameter identifiziert:

$$U_{EC} = U_{Batt} - OCV$$

$U_{EC}$ besteht nun aus den Spannungsabfällen über den Innenwiderstand und die zwei RC-Glieder:

$$U_{EC} = U_0 + U_{RC1} + U_{RC2}$$

Der Spannungsabfall am $RC_1$-Glied wird nach der z-Transformation beschrieben durch

$$u_{RC1}(k) = \frac{b_1}{z - a_1} * i(k)$$

mit

$$a_1 = e^{\frac{-Ts}{\tau_1}}$$

$$b_1 = R_1 * (1 - a_1)$$

wobei $\tau_1$ und $R_1$ die Parameter des RC-Gliedes darstellen. Gleiches gilt für das $RC_2$-Glied mit $\tau_2$ und $R_2$.

Durch diese Beschreibung kann die Gleichung für die Spannung $U_{EC}$ aufgestellt werden:

$$U_{EC}(k) = \left( R_0 + \frac{b_1}{z - a_1} + \frac{b_2}{z - a_2} \right) * i(k) + c_0$$

Mit den Koeffizienten

$$\theta_{d,0} = a_1 + a_2$$

$$\theta_{d,1} = a_1 * a_2$$

$$\theta_{n,2} = R_0$$

$$\theta_{n,1} = b_1 + b_2 - R_0 * (a_1 + a_2)$$

$$\theta_{n,0} = R_0 * a_1 * a_2 - a_2 * b_1 - a_1 * b_2$$

können die Systemgleichungen definiert werden:

$$y(k) = z^2 U_{EC}(k)$$

$$\theta = \left[\theta_{d,0}, \theta_{d,1}, \theta_{n,2}, \theta_{n,1}, \theta_{n,0}, \left(1 - \theta_{d,0} - \theta_{d,1}\right)c_0\right]^T$$

$$\phi(k) = \left[zU_{EC}(k), U_{EC}(k), z^2 i(k), z i(k), i(k), 1\right]^T$$

die über

$$y(k) = \theta^T * \phi(k)$$

die Spannung $U_{EC}(k)$ beschreiben. Mit der bekannten Kostenfunktion der Least-Squares-Methode

$$J = \sum \left[y(k) - \theta^T * \phi(k)\right]^2$$

und deren Inversion können die Parameter in $\theta$ gefunden werden.

$$\theta = \left(\Phi^T * \Phi\right)^{-1} * \Phi^T * Y$$

Optional können hierbei auch auftretende fehlerbehaftete Signale, Verrauschung oder Signallücken berücksichtigt werden, die zu Instabilitäten in den Identifikations-Algorithmen führen können.

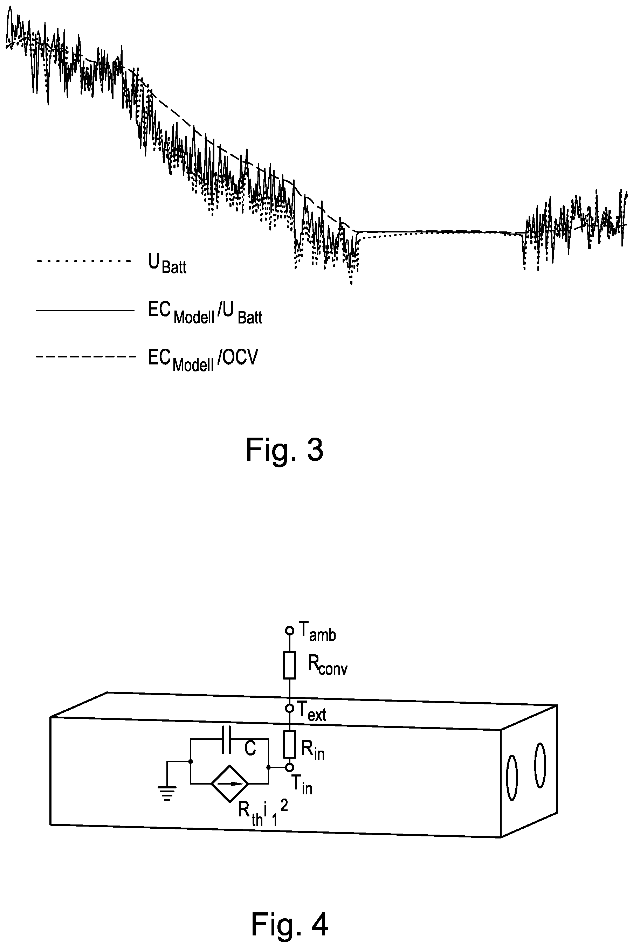

Fig. 3 zeigt den Vergleich zwischen simulierter Zellspannung $EC_{Model}/U_{Batt}$ und gemessener Zellspannung $U_{Batt}$.

Thermisches Modell:

Die Berücksichtigung eines thermischen Modells ist besonders vorteilhaft, da die EC-Parameter abhängig von der Zelltemperatur sind, allerdings nur die Oberflächentemperatur gemessen werden kann.

Das verwendete vereinfachte thermische Modell (siehe Fig. 4) geht davon aus, dass die gesamte Wärmemenge, die durch den Leistungsabfall über die Innenwiderstände bedingt ist, punktförmig in der Mitte der Zelle erzeugt wird.

$$\dot{Q}_{Inr} = R_{ges} * I_{Batt}^2$$

Über die Wärmekapazität $c_{Li}$ und Masse $m_{Cell}$ der Zelle kann eine Temperaturerhöhung der Kerntemperatur beschrieben werden.

$$\Delta T_{Inr} = \int \left(\dot{Q}_{Inr} - \dot{Q}_{cond}\right) * c_{Li} * m_{Cell}$$

Dadurch stellt sich ein Wärmestrom $\dot{Q}_{cond}$ zur Oberfläche ein, welcher die Oberflächentemperatur erhöht und die Kerntemperatur senkt.

$$\Delta T_{Surf} = \int \left(\dot{Q}_{cond} - \dot{Q}_{rad} - \dot{Q}_{conv}\right) * c_{Surf} * m_{Surf}$$

Durch Konvektion $\dot{Q}_{conv}$ und Strahlung $\dot{Q}_{rad}$ gibt die Zelle dann Wärme an die Umgebung ab.

Optional können im Batteriegrundmodell GM auch die zwischen den Zellen der Fahrzeugbatterie vorliegende Innenwiderstände, die z.B. durch Verkabelung und/oder Verschweißung verursacht werden, berücksichtigt werden.

Da eine Fahrzeugbatterie, z.B. eines Elektroautos, aus bis zu 188 in Serie geschalteten Zellen besteht, wird als Grundlage für die Parametrierung des Batteriegrundmodells GM im ersten Ausführungsbeispiel ein Zellmodell gewählt. Daher werden zur Erstellung des fahrzeugspezifischen Batteriemodells FM im ersten Ausführungsbeispiel den Batterieparametern des Batteriegrundmodells GM vorab Werte auf Grundlage der Vermessung einzelner Zellen der Fahrzeugbatterie zugeordnet. Dazu werden Zellenspannung und/oder Zellenstrom einzelner Zellen gemessen und anschließend auf die Fahrzeugbatterie extrapoliert.

Dies Vermessung einzelner Zellen erfolgt im ersten Ausführungsbeispiel im Rahmen eines Zell-Tests, der folgende Zyklen umfasst:

- Einen Zyklus zur Identifikation der Leerlaufspannungskennlinie $OCV_{cell}$, wobei eine langsame Ladung und Entladung der Fahrzeugbatterie bei 25°C mit C/20 vorgenommen wird.
- Zyklen zur Identifikation des thermischen Modells und zur Validierung des Gesamtmodells, wobei jeweils ein HPPC (Hybrid Puls Power Characterization)-Zyklus bei verschiedenen Temperaturen von z.B. -10°C, 0°C, 10°C, 25°C, 45°C durchgeführt wird.
- Einen simulierten Fahrzyklus zur Identifikation der EC-Parameter, der jeweils bei verschiedenen Temperaturen von z.B. z.B. -10°C, 0°C, 10°C, 25°C, 45°C durchgeführt wird.

Kapazität-OCV:

Der Kapazitäts- bzw. OCV-Zyklus dient zur Kapazitätsvermessung und zur Bestimmung der Leerlaufspannungskennlinie $OCV_{cell}$ der Zelle. Dies ist vorteilhaft, da die Zellen in ihrer Kapazität einer starken Serienstreuung unterliegen und der Wert aus dem Datenblatt nur einen Mindestwert darstellt. Für die Bestimmung der Leerlaufspannungskennlinie $OCV_{cell}$ der Zelle muss jedoch die Kapazität mit hoher Genauigkeit bestimmt werden.

Dieser Zyklus wird durch folgende Charakteristik beschrieben:

Die Zelle befindet sich im Zustand leer (0% SoC oder min. Zellspannung laut Datenblatt auch Entladeschlussspannung genannt). Beginn der Ladung mit konstanter C-Rate, bis die Ladschlussspannung erreicht ist. Diese Phase wird CC (Constant Current)-Phase genannt. Danach beginnt die CV (Constant Voltage)-Phase, in dieser Phase wird die Spannung solange auf der Ladeschlussspannung gehalten bis der Ladestrom eine Schwelle von 0.025C unterschreitet. Danach erfolgt eine einstündige Pause, in welcher sich die Zelle erholt und abkühlt. Anschließend beginnt die Entladung, mit der gleichen C-Rate wie beim Laden, bis zum Erreichen der Entladeschlussspannung. Hier beginnt wieder die CV-Phase bis der Entladestrom 0.025C unterschreitet. Dieser Zyklus wird mehrere Male wiederholt und dabei die C-Rate zwischen 0.1-1C und die Temperatur zwischen -10° und 40°C variiert.

HPPC bzw. GITT:

Der HPPC-Zyklus ist die Erweiterung des GITT (Galvanostatic Intermittent Titration Technique)-Zyklus bei dem pulsförmige Ladungen und Entladungen vorgenommen werden. Beim HPPC-Zyklus werden diese Pulse mit unterschiedlichen Amplituden und auch wechselnder Polarität ausgeführt. Fig. 4 zeigt einen beispielhaften Verlauf eines derartigen HPPC-Zyklus.

Der HPPC-Zyklus wird verwendet, um die aus Fahrzyklen identifizierten Parameter zu überprüfen und zu plausibilisieren. Um den HPPC-Zyklus für die Identifikation der Temperaturabhängigkeit der Parameter zu verwenden und das thermische Modell zu verifizieren, wird zwischen den einzelnen HPPC-Stufen eine mehrstündige Pause gemacht, damit sich die Zelle wieder auf Umgebungstemperatur abkühlen kann.

Fahrzyklus:

Beim Fahrzyklus-Test ist es möglich, einen realen Fahrzyklus aus einer Datenbank auf eine beliebige Zelle im Zellteststand aufzuprägen. Dieser Zyklus eignet sich durch die hohe Dynamik im Stromsignal am besten zur Identifikation der EC-Parameter mittels Least Squares-Algorithmen.

Diese Zyklen werden auf Einzelzellen bzw. Zellpacks, welche in den verschiedenen Elektroautos verbaut sind, angewendet, um Werte für die Batterieparameter des Batteriegrundmodells GM zu identifizieren. Diese für einzelne Zellen bzw. Zellpacks ermittelten Werte werden, abhängig von Verschaltung der Einzelzellen im Fahrzeug, auf die Fahrzeugbatterie hochskaliert, um ein fahrzeugtypspezifisches Batteriemodell FM zu erhalten. Um die Serienstreuung der Zellen zu berücksichtigen, werden diese Zell-Tests bei mehreren Zellen desselben Typs angewandt.

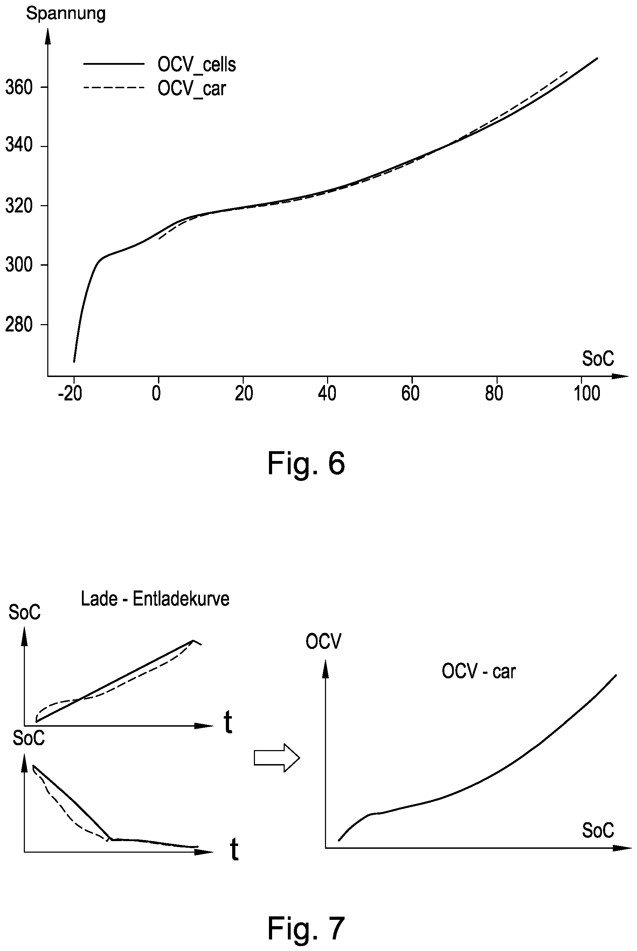

Diese Skalierung ist am Beispiel der Leerlaufspannungskennlinie OCV in Fig. 6 dargestellt. In Fig. 6 sind die Leerlaufspannungskennlinie $OCV_{cell}$ einer ersten Zellvermessung im Labor, sowie die Leerlaufspannungskennlinie $OCV_{car}$ der Fahrzeugbatterie im Fahrzeug dargestellt. Die Leerlaufspannungskennlinie $OCV_{cell}$ der Zelle und $OCV_{car}$ der Fahrzeugbatterie und sind im mittleren Bereich deckungsgleich.

**Fahrzeugspezifisches Batteriemodell FM:**

Die Werte, die den Batterieparametern des Batteriegrundmodells GM zugewiesen werden, sind jedoch alterungs- und temperaturabhängig. Daher werden anschließend die den Batterieparametern des Batteriegrundmodells GM zugeordneten Werte auf Grundlage der während der Belastung der Fahrzeugbatterie ermittelten Batterieparameter angepasst und das fahrzeugspezifische Batteriemodell FM wird auf diese Weise erstellt. Dabei werden die den Batterieparametern des Batteriegrundmodells GM zugeordneten Werte in Abhängigkeit von der während der Belastung der Fahrzeugbatterie ermittelten Zelltemperatur und/oder dem Ladezustand und/oder der Alterung der Fahrzeugbatterie angepasst.

Dazu können die Werte, die den Batterieparametern des Batteriegrundmodells GM zunächst zugewiesen werden, beispielsweise durch eine Belastung in Form einer Testfahrt mit dem Fahrzeug festgelegt und z.B. mittels Lookup-Tables gegenüber der Temperatur angepasst werden. So ist es möglich, nach einer kurzen Testfahrt ein digitales Abbild der Fahrzeugbatterie und gleichzeitig Werte für den Innenwiderstand $R_0$ zu erhalten, um anschließend Aussagen über den Zustand der Fahrzeugbatterie machen zu können.

Die Fahrzeugbatterie kann einerseits belastet werden, indem eine Vollentleerungs-Testfahrt mit dem Fahrzeug unternommen wird. Dabei wird die Fahrzeugbatterie zunächst vollständig geladen und während der Vollentleerungs-Testfahrt von ihrem vollständig geladenen Zustand bis zu ihrem vollständig entladenen Zustand entleert.

So kann eine Vollentleerungs-Testfahrt durchgeführt werden, wobei eine zuvor beschriebene Datenübertragungseinheit an das Fahrzeug angeschlossen ist. Die gemessenen Parameter Batteriepackstrom, Batteriepackspannung, Batteriemodultemperatur, Ladezustand SoC, Umgebungstemperatur, Zellspannungen werden an Datenspeicher bzw. den Server übertragen.

Nach beendeter Testfahrt werden die gesammelten Daten geglättet, synchronisiert und daraus die den Batterieparametern des Batteriegrundmodells GM zugeordneten Werte angepasst. Zur Schätzung der Werte der Batterieparameter des Batteriegrundmodells GM wird ein Identifikations-Algorithmus, wie dies zuvor im Abschnitt "EC-Parameter-Identifikation" beschrieben wurde.

Die so bestimmten Werte der Batterieparameter des Batteriegrundmodells GM basierend auf den Umgebungsparametern der Testfahrt, sind also gültig für den gefahrenen Ladezustands-Bereich und die Zelltemperatur währen der Testfahrt. Da diese Modellparameter allerdings stark von der Temperatur und dem Ladezustand abhängig sind, werden die Modellparameter anschließend vorteilhafterweise normiert. Die geschätzten Werte der Batterieparameter des Batteriegrundmodells GM werden nun mittels des Batteriegrundmodells GM, das durch Zell-Tests festgelegt wurde und auf 25°C normiert, da die Messung bei verschiedenen Umweltbedingungen stattfinden können, sodass eine Normierung auf Standard-Bedingungen vorteilhaft ist. Auf diese Weise wird das fahrzeugspezifische Batteriemodell FM erstellt.

Im gezeigten Ausführungsbeispiel wird vorteilhafterweise die Testzeit im Vergleich zu einer derartigen Vollentleerungstestfahrt wesentlich verkürzt, z.B. auf eine Dauer von 30 Minuten, indem eine Teilentleerungs-Testfahrt mit dem Fahrzeug unternommen wird, wobei die Fahrzeugbatterie während der Teilentleerungs-Testfahrt teilweise entleert wird und die während der Teilentleerungs-Testfahrt ermittelten Batterieparameter unter Heranziehung von historischen Daten und/oder Labordaten auf den vollständig entleerten Zustand extrapoliert werden.

Wie zuvor für die Vollentleerungs-Testfahrt beschrieben, werden auch bei der Teilentleerungs-Testfahrt die geschätzten Werte der Batterieparameter des Batteriegrundmodells GM mittels des Batteriegrundmodells, das durch Zell-Tests festgelegt wurde und auf 25°C normiert, anschließend auf den gesamten möglichen Ladezustands-Bereich von 0% bis 100% extrapoliert und auf diese Weise wird das fahrzeugspezifische Batteriemodell FM erstellt.

Weiters alternativ dazu kann die Testzeit vorteilhafterweise wesentlich verkürzt werden, wenn die Fahrzeugbatterie belastet wird, indem eine Ladung der Fahrzeugbatterie entsprechend zumindest einem vorgegebenen Lademuster durchgeführt wird.

Das Lademuster besteht je nach Fahrzeug aus Phasen eines invertierten Fahrzyklus (EC-Parameter Bestimmung) und aus Phasen eines HPPC-Zyklus (EC-Parameter Verifikation). Dabei wird die Fahrzeugbatterie in möglichst kurzer Zeit um ca. 20% geladen. Am Beginn und Ende des Zyklus sind Pausen von ca. 30min um die Leerlaufspannungskennlinie OCV zu messen. Der Ladezustand zu Testbeginn liegt vorzugsweise zwischen 30-60%.

Durch das spezielle Lademuster welches auf gute Identifizierbarkeit der EC-Parameter ausgelegt ist, kann bereits nach kurzer Ladung von wenigen % auf den gesamten Ladezustands-Bereich extrapoliert werden und eine Ermittlung des Gesundheitszustands SoH durchgeführt werden.

**Bestimmung des Gesundheitszustands SoH:**

Mit dem erstellten fahrzeugspezifischen Batteriemodell FM kann nun eine Vollladung sowie eine komplette Entladung simuliert werden, um die Kapazität der Fahrzeugbatterie bzw. deren Gesundheitszustand SoH zu bestimmen.

Da nun das fahrzeugspezifische Batteriemodell FM mit der realen Batterie übereinstimmt, kann unter Belastung auf die Leerlaufspannung $OCV_{car}$ zurückgerechnet werden. Wenn zusätzlich der Zusammenhang zwischen der Leerlaufspannung $OCV_{cell}$ und dem Ladezustand einzelner Zellen der Fahrzeugbatterie, d.h. die Leerlaufspannungs-Ladezustand-Kurve, der Zelle bekannt ist, kann damit auf den aktuellen Ladezustand SoC geschlossen werden (siehe schematische Darstellung in Fig. 7).

Dadurch ist es möglich, auch wenn nur ein Teil der Ladung L oder Entladung E aufgezeichnet wird, auf den Gesundheitszustand SoH der Fahrzeugbatterie zu schließen (siehe schematische Ablaufdarstellung in Fig. 2). Dies erfolgt im Ausführungsbeispiel, indem über einen Coulomb-Zähler und die entsprechende Ladezustands-Änderung auf den vollständig entleerten bzw. geladenen Zustand extrapoliert wird. Der Coulomb-Zähler misst die eingespeiste Ladung und zieht die entnommene Ladung davon ab, um auf die Kapazität zu schließen.

Mit dem normierten und ggf. extrapolierten fahrzeugspezifischen Batteriemodell FM wird im Ausführungsbeispiel ein WLPT (Worldwide Harmonized Light-Duty Vehicle Test Procedure) - Zyklus simuliert. Dazu wird das Modell mit einem vorgegebenen Stromprofil, das angepasst an das Fahrzeug ist, bestromt. Aus der Simulation wird die Energie, welche aus der Batterie während des WLPT-Zyklus entnommen wird, berechnet und ins Verhältnis mit der nominalen Energie des Fahrzeugs gesetzt, um somit den Gesundheitszustand SoH zu berechnen.

Optional ist es auch möglich, dass auch eine Reichweitenschätzung beim aktuellen Gesundheitszustand SoH der Fahrzeugbatterie durchgeführt wird, wenn das fahrzeugspezifische Batteriemodell dem WLTP-Zyklus, unterworfen wird.

Wird der Gesundheitszustand SoH eines anderen Batteriesystems berechnet, wie z.B. eines Flugzeugs, oder stationärer Speichersysteme, sind anstelle von Testfahrten bzw. -flügen vorgegebene Lademuster besonders vorteilhaft.

## Patentansprüche

1. Verfahren zur Ermittlung des Gesundheitszustands der Fahrzeugbatterie eines Elektrofahrzeugs oder Hybridelektrofahrzeugs umfassend folgende Schritte:

   - Belasten der Fahrzeugbatterie und Ermitteln von vorgegebenen Batterieparametern, insbesondere Batteriepackspannung, Batteriepackstrom, Zellenspannung, Batteriemodultemperatur und/oder Ladezustand, vorzugsweise durch das Batteriemanagementsystem des Fahrzeugs, während der Belastung,
   - Übertragen der ermittelten Batterieparameter mittels einer an einen Diagnoseanschluss des Fahrzeugs ansteckbaren Datenübertragungseinheit, vorzugsweise in Echtzeit, an einen, insbesondere vom Fahrzeug getrennten, Datenspeicher und
   - Berechnen des Gesundheitszustands der Fahrzeugbatterie auf einem mit dem Datenspeicher in Datenkommunikation stehenden Server unter Heranziehung eines fahrzeugspezifischen Batteriemodells (FM) basierend auf den übertragenen Batterieparametern.

   **dadurch gekennzeichnet,**
   **dass** als fahrzeugspezifisches Batteriemodell (FM) zunächst ein vom Typ der Fahrzeugbatterie abhängiges Batteriegrundmodell (GM) in Form eines elektrischen Ersatzschaltbild-Modells herangezogen wird, wobei das Batteriegrundmodell (GM) eine Spannungsquelle, einen Innenwiderstand ($R_0$) und eine Anzahl von, insbesondere zwei, RC-Gliedern ($RC_1$, $RC_2$) umfasst,
   - wobei der Innenwiderstand ($R_0$) und die RC-Glieder ($RC_1$, $RC_2$) als Funktion der Zelltemperatur und des Ladezustands festgelegt werden,
   - wobei eine Leerlaufspannungskennlinie (OCV) als Funktion des Ladezustands festgelegt wird und
   - wobei die Zelltemperatur mittels eines thermischen Modells in Abhängigkeit von dem gemessenen Batteriepackstrom, EC-Parametern, welche Parameter des elektrischen Ersatzschaltbild-Modells sind, der Batteriemodultemperatur und einer Umgebungstemperatur festgelegt wird.

2. Verfahren nach Anspruch 1, **dadurch gekennzeichnet, dass**, insbesondere vorab, den Batterieparametern des Batteriegrundmodells (GM) Werte auf Grundlage der Vermessung einzelner Zellen der Fahrzeugbatterie, insbesondere der Messung der Zellenspannung und/oder Zellenstrom einzelner Zellen, zugeordnet werden, wobei insbesondere vorgesehen ist, dass die Leerlaufspannungskurve ($OCV_{cell}$) für zumindest eine einzelne Zelle, vorzugsweise mehrere einzelne Zellen, ermittelt wird und auf Grundlage der für die einzelne Zelle ermittelten Leerlaufspannungskurve ($OCV_{cell}$) die Leerlaufspannungskurve ($OCV_{car}$) der Fahrzeugbatterie abgeschätzt wird.

3. Verfahren nach Anspruch 1 oder 2, **dadurch gekennzeichnet, dass** die den Batterieparametern des Batteriegrundmodells (GM) zugeordneten Werte auf Grundlage der während der Belastung der Fahrzeugbatterie ermittelten Batterieparameter angepasst werden und derart das fahrzeugspezifische Batteriemodell (FM) erstellt wird.

4. Verfahren nach einem der Ansprüche 1 bis 3, **dadurch gekennzeichnet, dass** die den Batterieparametern des Batteriegrundmodells (GM) zugeordneten Werte in Abhängigkeit von der während der Belastung der Fahrzeugbatterie ermittelten Zelltemperatur und/oder dem Ladezustand und/oder der Alterung der Fahrzeugbatterie angepasst werden.

5. Verfahren nach Anspruch 4, **dadurch gekennzeichnet,**

- **dass** die Fahrzeugbatterie belastet wird, indem eine Testfahrt mit dem Fahrzeug unternommen wird,
- **dass** für die Batterieparameter des Batteriegrundmodells (GM) für den während der Testfahrt vorherrschenden Ladezustand und die vorherrschende Zelltemperatur gültige Werte ermittelt werden, und
- **dass** die derart ermittelten Werte mittels der, insbesondere gemäß Anspruch 3, auf Grundlage der Vermessung einzelner Zellen der Fahrzeugbatterie bestimmten Werte auf eine vorgegebene Temperatur, insbesondere von 25°C, normiert und zur Erstellung des fahrzeugspezifischen Batteriemodells (FM) auf einen vorgegebenen Ladezustandsbereich, insbesondere von 0 bis 100%, extrapoliert werden.

6. Verfahren nach einem der Ansprüche 1 bis 5, **dadurch gekennzeichnet, dass** im Batteriegrundmodell (GM) und/oder im fahrzeugspezifischen Batteriemodell (FM) zwischen den Zellen der Fahrzeugbatterie vorliegende Innenwiderstände, insbesondere verursacht durch Verkabelung und/oder Verschweißung, berücksichtigt werden.

7. Verfahren nach einem der vorangehenden Ansprüche, **dadurch gekennzeichnet, dass** das fahrzeugspezifische Batteriemodell (FM) einem vorgegebenen Testzyklus, insbesondere einem WLTP-Zyklus (Worldwide harmonized Light vehicles Test Procedure), unterworfen wird und eine Reichweitenschätzung beim aktuellen Gesundheitszustand der Fahrzeugbatterie durchgeführt wird, wobei insbesondere vorgesehen ist, dass das fahrzeugspezifische Batteriemodell (FM) gemäß einem vorgegebenen Stromprofil mit Strom versorgt wird.

8. Verfahren nach einem der vorangehenden Ansprüche, **dadurch gekennzeichnet, dass** die Fahrzeugbatterie belastet wird, indem eine Vollentleerungs-Testfahrt mit dem Fahrzeug unternommen wird, wobei die Fahrzeugbatterie während der Vollentleerungs-Testfahrt von ihrem vollständig geladenen Zustand bis zu ihrem vollständig entladenen Zustand entleert wird.

9. Verfahren nach einem der vorangehenden Ansprüche, **dadurch gekennzeichnet, dass** die Fahrzeugbatterie belastet wird, indem

- eine Ladung der Fahrzeugbatterie entsprechend zumindest einem vorgegebenen Lademuster durchgeführt wird und/oder
- eine Teilentleerungs-Testfahrt mit dem Fahrzeug unternommen wird, wobei die Fahrzeugbatterie während der Teilentleerungs-Testfahrt teilweise entleert wird und die während der Teilentleerungs-Testfahrt ermittelten Batterieparameter unter Heranziehung von historischen Daten und/oder Labordaten auf den vollständig entleerten Zustand extrapoliert werden.

10. Verfahren nach einem der vorangehenden Ansprüche, **dadurch gekennzeichnet, dass** basierend auf dem fahrzeugspezifischen Batteriemodell (FM) unter Belastung auf einem Prüfstand die Leerlaufspannung ($OCV_{car}$) der Fahrzeugbatterie durch bekannte EC-Parameter berechnet wird,

- wobei der Zusammenhang zwischen der Leerlaufspannung ($OCV_{cell}$) und dem Ladezustand (SoC) einzelner Zellen der Fahrzeugbatterie, insbesondere die Leerlaufspannungs-Ladezustand-Kurve, vorgegeben wird,
- wobei der aktuelle Ladezustand (SoC) der Fahrzeugbatterie basierend auf der Leerlaufspannung (OCV) ermittelt wird und
- wobei der Gesundheitszustand (SoH) der Fahrzeugbatterie ermittelt wird, indem mittels eines Coulomb-Zählers und der entsprechenden Änderung des Ladezustands (SoC) auf den vollständig entleerten oder geladenen Zustand extrapoliert wird.

11. Verfahren nach einem der vorangehenden Ansprüche, **dadurch gekennzeichnet, dass** der Gesundheitszustand der Fahrzeugbatterie berechnet wird, nachdem die Belastung der Fahrzeugbatterie und die Übertragung der während der Belastung der Fahrzeugbatterie ermittelten Batterieparametermesswerte an den Datenspeicher abgeschlossen ist.

12. Verfahren nach einem der vorangehenden Ansprüche, **dadurch gekennzeichnet, dass** die an den Datenspeicher übermittelten Batterieparameter einzelnen Datenverarbeitungsschritten, insbesondere einer Glättung und/oder Synchronisierung und/oder einem Resampling, unterzogen werden.

13. Anordnung zur Ermittlung des Gesundheitszustands der Fahrzeugbatterie eines Elektrofahrzeugs oder Hybridelektrofahrzeugs, insbesondere zur Durchführung eines Verfahrens nach einem der Ansprüche 1 bis 12, umfassend:

- einen, insbesondere vom Fahrzeug getrennten, Datenspeicher,
- eine an einen Diagnoseanschluss des Fahrzeugs ansteckbare Datenübertragungseinheit, die dazu ausgebildet ist, vorgegebene, während einer Belastung der Fahrzeugbatterie, vorzugsweise durch das Batteriemanagementsystem des Fahrzeugs, ermittelte Batterieparameter an den Datenspeicher zu übertragen, und
- einen mit dem Datenspeicher in Datenkommunikation stehenden Server, der dazu ausgebildet ist, basierend auf den Batterieparametern den Gesundheitszustand der Fahrzeugbatterie unter Heranziehung eines fahrzeugspezifischen Batteriemodells (FM) zu berechnen,
**dadurch gekennzeichnet,**
**dass** der Server dazu ausgebildet ist, als fahrzeugspezifisches Batteriemodell (FM) zunächst ein vom Typ der Fahrzeugbatterie abhängiges Batteriegrundmodell (GM) in Form eines elektrischen Ersatzschaltbild-Modells heranzuziehen, wobei das Batteriegrundmodell (GM) eine Spannungsquelle, einen Innenwiderstand ($R_0$) und eine Anzahl von, insbesondere zwei, RC-Gliedern ($RC_1$, $RC_2$) umfasst,
- wobei der Innenwiderstand ($R_0$) und die RC-Glieder ($RC_1$, $RC_2$) als Funktion der Zelltemperatur und des Ladezustands festgelegt werden,
- wobei eine Leerlaufspannungskennlinie (OCV) als Funktion des Ladezustands festgelegt wird und
- wobei die Zelltemperatur mittels eines thermischen Modells in Abhängigkeit von einem gemessenen Batteriepackstrom, EC-Parametern, welche Parameter des elektrischen Ersatzschaltbild-Modells sind, einer Batteriemodultemperatur und einer Umgebungstemperatur festgelegt wird.

## Claims

1. Method for determining the health status of the vehicle battery of an electric vehicle or hybrid electric vehicle, comprising the following steps:

- loading the vehicle battery and determining predetermined battery parameters, in particular battery pack voltage, battery pack current, cell voltage, battery module temperature and/or state of charge, preferably by the vehicle's battery management system, during the loading,
- transmitting the determined battery parameters by means of a data transmission unit that can be plugged into a diagnosis connection of the vehicle, preferably in real time, to a data memory, in particular separate from the vehicle, and
- calculating the health status of the vehicle battery on a server in data communication with the data memory using a vehicle-specific battery model (FM) based on the transmitted battery parameters.
**characterised in**
**that** a battery base model (GM) which is dependent on the type of vehicle battery and is in the form of an electrical equivalent circuit model is initially used as the vehicle-specific battery model (FM), wherein the battery base model (GM) comprises a voltage source, an internal resistance ($R_0$) and a number of, in particular two, RC elements ($RC_1$, $RC_2$),
- wherein the internal resistance ($R_0$) and RC elements ($RC_1$, $RC_2$) are determined as a function of cell temperature and state of charge,
- wherein an open circuit voltage characteristic (OCV) is established as a function of the state of charge, and
- wherein the cell temperature is determined by means of a thermal model as a function of the measured battery pack current, EC parameters which are parameters of the electrical equivalent circuit model, the battery module temperature and an ambient temperature.

2. Method according to claim 1, **characterised in that**, in particular in advance, values are assigned to the battery parameters of the battery base model (GM) on the basis of the measurement of individual cells of the vehicle battery, in particular the measurement of the cell voltage and/or cell current of individual cells, wherein it is particularly provided that the open circuit voltage curve ($OCV_{cell}$) is determined for at least one individual cell, preferably several individual cells, and, on the basis of the open circuit voltage curve ($OCV_{cell}$) determined for the individual cell, the open circuit voltage curve ($OCV_{car}$) of the vehicle battery is estimated.

3. Method according to claim 1 or 2, **characterised in that** the values assigned to the battery parameters of the battery base model (GM) are adapted on the basis of the battery parameters determined during the loading of the vehicle battery, and the vehicle-specific battery model (FM) is created in this way.

4. Method according to any one of claims 1 to 3, **characterised in that** the values assigned to the battery parameters of the battery base model (GM) are adjusted as a function of the cell temperature determined during the loading of the vehicle battery and/or the state of charge and/or the aging of the vehicle battery.

5. Method according to claim 4, **characterised in**:

- **that** the vehicle battery is loaded by taking a test drive with the vehicle,
- **that** valid values are determined for the battery parameters of the battery base model (GM) for the prevalent state of charge and the prevalent cell temperature during the test drive, and
- **that** the values determined in this way are normalized to a predetermined temperature, in particular of 25 °C, by means of the values determined, in particular according to claim 3, on the basis of the measurement of individual cells of the vehicle battery, and extrapolated to a predetermined state of charge range, in particular from 0 to 100%, in order to create the vehicle-specific battery model (FM).

6. Method according to any one of claims 1 to 5, **characterised in that** internal resistances present between the cells of the vehicle battery, in particular caused by wiring and/or welding, are taken into account in the battery base model (GM) and/or in the vehicle-specific battery model (FM).

7. Method according to any one of the preceding claims, **characterised in that** the vehicle-specific battery model (FM) is subjected to a predetermined test cycle, in particular a WLTP cycle (Worldwide harmonized Light vehicles Test Procedure), and a range estimate is performed at the current health status of the vehicle battery, wherein it is provided in particular that the vehicle-specific battery model (FM) is supplied with current according to a predetermined current profile.

8. Method according to any one of the preceding claims, **characterised in that** the vehicle battery is loaded by taking a complete discharge test drive with the vehicle, wherein the vehicle battery is discharged from its completely charged state to its completely discharged state during the complete discharge test drive.

9. Method according to any one of the preceding claims, **characterised in that** the vehicle battery is loaded by

- carrying out a charge the vehicle battery according to at least one predetermined charging pattern and/or
- undertaking a partial discharge test drive with the vehicle, wherein the vehicle battery is partially discharged during the partial discharge test drive and the battery parameters determined during the partial discharge test drive are extrapolated to the completely discharged state using historical data and/or laboratory data.

10. Method according to any one of the preceding claims, **characterised in that**, based on the vehicle-specific battery model (FM) under load on a test bench, the open circuit voltage ($OCV_{car}$) of the vehicle battery is calculated by known EC parameters,

- wherein the relationship between the open circuit voltage ($OCV_{cell}$) and the state of charge (SoC) of individual cells of the vehicle battery, in particular the open circuit voltage state of charge curve, is specified,
- wherein the current state of charge (SoC) of the vehicle battery is determined based on the open circuit voltage (OCV), and
- wherein the health status (SoH) of the vehicle battery is determined by extrapolating to the completely discharged or charged state by means of a Coulomb counter and the corresponding change in the state of charge (SoC).

11. Method according to any one of the preceding claims, **characterised in that** the health status of the vehicle battery is calculated after the loading of the vehicle battery and the transfer of the battery parameter measurement values determined during the loading of the vehicle battery to the data memory is completed.

12. Method according to any one of the preceding claims, **characterised in that** the battery parameters transmitted to the data memory are subjected to individual data processing steps, in particular smoothing and/or synchronization and/or resampling.

13. Arrangement for determining the health status of the vehicle battery of an electric vehicle or hybrid electric vehicle, in particular for carrying out a method according to any one of claims 1 to 12, comprising:

- a data memory, in particular one that is separate from the vehicle,
- a data transmission unit which can be plugged into a diagnosis connection of the vehicle and which is designed to transmit predetermined battery parameters determined during a loading of the vehicle battery, preferably by the battery management system of the vehicle, to the data memory, and
- a server in data communication with the data memory, which is designed to calculate the health status of the vehicle battery based on the battery parameters using a vehicle-specific battery model (FM),

**characterised in**

**that** the server is designed to first use as a vehicle-specific battery model (FM) a battery base model (GM) in the form of an electrical equivalent circuit model which depends on the type of vehicle battery, wherein the battery base model (GM) comprises a voltage source, an internal resistance ($R_0$) and a number of, in particular two, RC elements ($RC_1$, $RC_2$),
- wherein the internal resistance ($R_0$) and RC elements ($RC_1$, $RC_2$) are determined as a function of cell temperature and state of charge,
- wherein an open circuit voltage characteristic (OCV) is established as a function of the state of charge, and
- wherein the cell temperature is determined by means of a thermal model as a function of a measured battery pack current, EC parameters which are parameters of the electrical equivalent circuit model, a battery module temperature, and an ambient temperature.

**Revendications**

1. Procédé de détermination de l'état de santé de la batterie de véhicule d'un véhicule électrique ou véhicule électrique hybride comprenant les étapes suivantes :

- la charge de la batterie de véhicule et la détermination de paramètres de batterie prédéfinis, en particulier tension du bloc-batterie, courant du bloc-batterie, tension de cellule, température du module de batterie et/ou état de charge, de préférence par le système de gestion de batterie du véhicule, pendant la charge,
- la transmission des paramètres de batterie déterminés au moyen d'une unité de transmission de données enfichable sur un raccord de diagnostic du véhicule, de préférence en temps réel, à une mémoire de données, en particulier séparée du véhicule et
- le calcul de l'état de santé de la batterie de véhicule sur un serveur se trouvant en communication de données avec la mémoire de données à l'aide d'un modèle de batterie (FM) spécifique au véhicule sur la base de paramètres de batterie transmis,

**caractérisé en ce que**

comme modèle de batterie (FM) spécifique au véhicule, tout d'abord un modèle de base de batterie (GM) dépendant du type de la batterie de véhicule est utilisé sous la forme d'un modèle de circuit équivalent électrique, selon lequel le modèle de base de batterie (GM) comprend une source de tension, une résistance intérieure ($R_0$) et un nombre d'éléments RC ($RC_1$, $RC_2$), en particulier deux,
- selon lequel la résistance intérieure ($R_0$) et les éléments RC ($RC_1$, $RC_2$) sont déterminés en fonction de la température de cellule et de l'état de charge,
- selon lequel une caractéristique de tension de circuit ouvert (OCV) est déterminée en fonction de l'état de charge et
- selon lequel la température de cellule est déterminée au moyen d'un modèle thermique en fonction du courant de bloc-batterie mesuré, de paramètres EC qui sont des paramètres du modèle de circuit équivalent électrique, de la température du module de batterie et d'une température ambiante.

2. Procédé selon la revendication 1, **caractérisé en ce qu'**en particulier au préalable, des valeurs sont associées aux paramètres de batterie du modèle de base de batterie (GM) sur la base de la mesure de cellules individuelles de la batterie de véhicule, en particulier la mesure de la tension de cellule et/ou du courant de cellule de cellules individuelles, selon lequel il est en particulier prévu que la courbe de tension de circuit ouvert ($OCV_{cellule}$) soit déterminée pour au moins une cellule individuelle, de préférence plusieurs cellules individuelles et la courbe de tension de circuit ouvert ($OCV_{voiture}$) de la batterie de véhicule est estimée sur la base de la courbe de tension de circuit ouvert ($OCV_{cellule}$) déterminée pour la cellule individuelle.

3. Procédé selon la revendication 1 ou 2, **caractérisé en ce que** les valeurs associées aux paramètres de batterie du modèle de base de batterie (GM) sont adaptées sur la base des paramètres de batterie déterminés pendant la charge de la batterie de véhicule et le modèle de batterie (FM) spécifique au véhicule est établi de la sorte.

4. Procédé selon l'une quelconque des revendications 1 à 3, **caractérisé en ce que** les valeurs associées aux paramètres de batterie du modèle de base de batterie (GM) sont adaptées en fonction de la température de cellule déterminée pendant la charge de la batterie de véhicule et/ou de l'état de charge et/ou du vieillissement de la batterie de véhicule.

5. Procédé selon la revendication 4, **caractérisé en ce que**

   - la batterie de véhicule est chargée **en ce qu'**un test de conduite avec le véhicule est entrepris,
   - pour les paramètres de batterie du modèle de base de batterie (GM) pour l'état de charge régnant pendant le test de conduite et la température de cellule régnante, des valeurs valables sont déterminées, et
   - les valeurs déterminées de la sorte sont normées au moyen de valeurs déterminées en particulier selon la revendication 3, sur la base de la mesure de cellules individuelles de la batterie de véhicule à une température prédéfinie, en particulier de 25 °C et sont extrapolées pour l'établissement du modèle de batterie (FM) spécifique au véhicule sur une plage d'état de charge prédéfinie, en particulier de 0 à 100 %.

6. Procédé selon l'une quelconque des revendications 1 à 5, **caractérisé en ce que** des résistances intérieures se trouvant entre les cellules de la batterie de véhicule, en particulier causées par câblage et/ou soudage sont prises en compte dans le modèle de base de batterie (GM) et/ou dans le modèle de batterie (FM) spécifique au véhicule.

7. Procédé selon l'une quelconque des revendications précédentes, **caractérisé en ce que** le modèle de batterie (FM) spécifique au véhicule est soumis à un cycle test prédéfini, en particulier un cycle WLTP (Worldwide harmonized Light vehicles Test Procedure), et une estimation d'autonomie est réalisée pour l'état de santé actuel de la batterie de véhicule,
   selon lequel il est en particulier prévu que le modèle de batterie (FM) spécifique au véhicule soit alimenté en courant selon un profil de courant prédéfini.

8. Procédé selon l'une quelconque des revendications précédentes, **caractérisé en ce que** la batterie de véhicule est chargée, **en ce qu'**un test de conduite à vidage complet avec le véhicule est entrepris, selon lequel la batterie de véhicule est vidée pendant le test de conduite à vidage complet de son état complètement chargé à son état complètement déchargé.

9. Procédé selon l'une quelconque des revendications précédentes, **caractérisé en ce que** la batterie de véhicule est chargée, **en ce que**

   - une charge de la batterie de véhicule est réalisée selon au moins un modèle de charge prédéfini et/ou
   - un test de conduite à vidage partiel avec le véhicule est entrepris, selon lequel la batterie de véhicule est partiellement vidée pendant le test de conduite à vidage partiel et les paramètres de batterie déterminés pendant le test de conduite à vidage partiel sont extrapolés à l'aide de données historiques et/ou données de laboratoire sur l'état complètement vidé.

10. Procédé selon l'une quelconque des revendications précédentes, **caractérisé en ce que** la tension de circuit ouvert (OCV$_{voiture}$) de la batterie de véhicule est calculée par des paramètres EC connus sur la base du modèle de batterie (FM) spécifique au véhicule sous la charge sur un banc d'essai,

   - selon lequel le rapport entre la tension de circuit ouvert (OCV$_{cellule}$) et l'état de charge (SoC) de cellules individuelles de la batterie de véhicule, en particulier la courbe de tension de circuit ouvert-état de charge, est prédéfini(e),
   - selon lequel l'état de charge (SoC) actuel de la batterie de véhicule est déterminé sur la base de la tension de circuit ouvert (OCV) et
   - selon lequel l'état de santé (SoH) de la batterie de véhicule est déterminé **en ce qu'**au moyen d'un compteur de Coulomb et de la modification correspondante de l'état de charge (SoC), il est extrapolé sur l'état chargé ou complètement vidé.

11. Procédé selon l'une quelconque des revendications précédentes, **caractérisé en ce que** l'état de santé de la batterie de véhicule est calculé après que la charge de la batterie de véhicule et la transmission des valeurs de mesure de paramètre de batterie déterminées pendant la charge de la batterie de véhicule à la mémoire de données est terminée.

12. Procédé selon l'une quelconque des revendications précédentes, **caractérisé en ce que** les paramètres de batterie transmis à la mémoire de données sont soumis à des étapes de traitement de données individuelles, en particulier un lissage et/ou une synchronisation et/ou un rééchantillonnage.

13. Ensemble de détermination de l'état de santé de la batterie de véhicule d'un véhicule électrique ou véhicule électrique hybride, en particulier pour la réalisation d'un procédé selon l'une quelconque des revendications 1 à 12 comprenant :

- une mémoire de données séparée en particulier du véhicule,
- une unité de transmission de données enfichable sur un raccord de diagnostic du véhicule, unité qui est réalisée afin de transmettre des paramètres de batterie prédéfinis, déterminés pendant une charge de la batterie de véhicule, de préférence par le système de gestion de batterie du véhicule à la mémoire de données, et
- un serveur se trouvant en communication de données avec la mémoire de données, serveur qui est réalisé afin de calculer sur la base des paramètres de batterie l'état de santé de la batterie de véhicule à l'aide d'un modèle de batterie (FM) spécifique au véhicule,

**caractérisé en ce que**

le serveur est réalisé afin d'utiliser comme modèle de batterie (FM) spécifique au véhicule, tout d'abord un modèle de base de batterie (GM) dépendant du type de la batterie de véhicule sous la forme d'un modèle de circuit équivalent électrique, selon lequel le modèle de base de batterie (GM) comprend une source de tension, une résistance intérieure ($R_0$) et un nombre d'éléments RC ($RC_1$, $RC_2$), en particulier deux,

- selon lequel la résistance intérieure ($R_0$) et les éléments RC ($RC_1$, $RC_2$) sont déterminés en fonction de la température de cellule et de l'état de charge,
- selon lequel une caractéristique de tension de circuit ouvert (OCV) est déterminée en fonction de l'état de charge et
- selon lequel la température de cellule est déterminée au moyen d'un modèle thermique en fonction d'un courant de bloc-batterie mesuré, de paramètres EC qui sont des paramètres du modèle de circuit équivalent électrique, d'une température de module de batterie et d'une température ambiante.

Fig. 1

Fig. 2

- - - - - - - - - - U$_{Batt}$

————— EC$_{Modell}$/U$_{Batt}$

- - - - - - - - EC$_{Modell}$/OCV

## Fig. 3

T$_{amb}$

R$_{conv}$

T$_{ext}$

C

R$_{in}$

T$_{in}$

R$_{th}$i$_1$$^2$

## Fig. 4

Fig. 5

EP 4 222 513 B1

Fig. 6

Fig. 7

**IN DER BESCHREIBUNG AUFGEFÜHRTE DOKUMENTE**

**In der Beschreibung aufgeführte Patentdokumente**

- EP 3224632 B1
- US 20160349330 A1
- US 20200269722 A1
- DE 102019111979 A1